(19) Europäisches Patentamt
European Patent Office
Office européen des brevets

(11) **EP 2 695 624 A1**

(12) **EUROPEAN PATENT APPLICATION**

(43) Date of publication:
**12.02.2014 Bulletin 2014/07**

(51) Int Cl.:
**A61M /** *(2006.01)*

(21) Application number: **13004739.2**

(22) Date of filing: **15.12.2010**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br><br>(30) Priority: **16.12.2009  US 287183 P**<br><br>(62) Document number(s) of the earlier application(s) in accordance with Art. 76 EPC:<br>**10793123.0 / 2 513 220**<br><br>(71) Applicant: **AVERY DENNISON CORPORATION Pasadena, CA 91103 (US)** | (72) Inventor: **Buehne, William, J.**<br>**Highland, IL 46322 (US)**<br><br>(74) Representative: **Müller-Boré & Partner**<br>**Patentanwälte PartG mbB**<br>**Grafinger Straße 2**<br>**81671 München (DE)**<br><br><u>Remarks:</u><br>This application was filed on 01-10-2013 as a divisional application to the application mentioned under INID code 62. |

(54) **Photovoltaic Backsheet**

(57)    The present invention relates to a photovoltaic backsheet comprising a cured coating disposed on a substrate, the coating prior to curing comprising: from about 80 to about 120 parts by weight of at least one fluorinated vinyl ether; from about 5 to about 35 parts by weight of at least one isocyanate crosslinker; and from about 50 to about 150 parts by weight of pigment dispersion.

FIG. 1

**Description**

CROSS REFERENCES TO RELATED APPLICATIONS

This application claims the benefit of U.S. Provisional Application No. 61/287,183 filed on December 16, 2009, which is incorporated herein by reference in its entirety.

FIELD OF INVENTION

The present inventive subject matter relates generally to the art of coated polymeric films. Particular application is found in connection with backsheets for photovoltaic modules and/or methods for making the same, and accordingly the present specification makes specific reference thereto. However, it is to be appreciated that aspects of the present inventive subject matter are also amenable to other applications.

Accordingly, new and/or improved photovoltaic modules, backsheets therefor and/or methods of making the same are disclosed that address one or more limitations, drawbacks and/or problems associated with previously developed photovoltaic modules, backsheets and/or methods for making the same.

SUMMARY OF THE INVENTION

The difficulties and drawbacks associated with previously known backsheets, compositions, and systems are addressed in the present backsheets, modules, and methods.

In one aspect, the present invention provides a photovoltaic backsheet comprising a cured coating disposed on a substrate. The coating prior to curing includes polyvinylidene fluoride and at least one acrylic polymer, wherein the weight percent of the at least one acrylic polymer is from about 20% to about 40% based upon the total weight of the polyvinylidene fluoride and the at least one acrylic polymer.

In another aspect, the present invention provides a photovoltaic backsheet comprising a cured coating on a substrate. The coating prior to curing comprises from about 20 to about 40 parts by weight of at least one acrylic polymer, from about 50 to about 120 parts by weight of polyvinylidene fluoride, from about 1 to about 20 parts by weight of crosslinker, and from about 50 to about 120 parts by weight of pigment.

In still another aspect, the present invention provides a photovoltaic backsheet comprising a cured coating disposed on a substrate. The coating prior to curing comprises from about 80 to about 120 parts by weight of at least one fluorinated vinyl ether, from about 5 to about 35 parts by weight of at least one isocyanate crosslinker, and from about 50 to about 150 parts by weight of pigment dispersion.

In yet another aspect, the present invention provides a photovoltaic module comprising at least one solar cell, and a backsheet disposed on the solar cell. The backsheet comprises a cured coating disposed on a substrate. The coating prior to curing includes polyvinylidene fluoride and at least one acrylic polymer. The weight percent of the at least one acrylic polymer is from about 20% to about 40% based upon the total weight of the polyvinylidene fluoride and the at least one acrylic polymer.

In still another aspect, the present invention provides a photovoltaic module comprising at least one solar cell, and a backsheet disposed on the solar cell. The backsheet comprises a cured coating on a substrate. The coating prior to curing comprises from about 20 to about 40 parts by weight of at least one acrylic polymer, from about 50 to about 120 parts by weight of polyvinylidene fluoride, from about 1 to about 20 parts by weight of crosslinker, and from about 50 to about 120 parts by weight of pigment.

In still another aspect, the invention provides a photovoltaic module comprising at least one solar cell and a backsheet disposed on the solar cell. The backsheet comprises a cured coating disposed on a substrate. The coating prior to curing comprises from about 80 to about 120 parts by weight of at least one fluorinated vinyl ether, from about 5 to about 35 parts by weight of at least one isocyanate crosslinker, and from about 50 to about 150 parts by weight of pigment dispersion.

In a further aspect, the present invention provides a method of forming a photovoltaic backsheet. The method comprises providing a substrate in the form of a thin film or sheet. The method also comprises obtaining a composition including polyvinylidene fluoride and at least one acrylic polymer, wherein the weight percent of the at least one acrylic polymer is from about 20% to about 40% based upon the total weight of the polyvinylidene fluoride and the at least one acrylic polymer. The method additionally comprises applying a coating of the composition on the substrate. And, the method comprises curing the coating on the substrate to thereby form the photovoltaic backsheet.

In another aspect, the present invention provides a method of forming a photovoltaic backsheet. The method comprises providing a substrate in the form of a thin film or sheet. The method also comprises obtaining a composition including from about 20 to about 40 parts by weight of at least one acrylic polymer, from about 50 to about 120 parts by weight of polyvinylidene fluoride, from about 1 to about 20 parts by weight of crosslinker, and from about 50 to about 120 parts by weight of pigment. And, the method also comprises applying a coating of the composition on the substrate. The method further comprises curing the coating on the substrate to thereby form the photovoltaic backsheet.

In still another aspect, the present invention provides a method of forming a photovoltaic backsheet. The method comprises providing a substrate in the form of a thin film or sheet. The method also comprises obtaining a composition including from about 80 to about 120 parts by weight of at least one fluorinated vinyl ether, from about 5 to about 35 parts by weight of at least one isocyanate crosslinker, and from about 50 to about 150 parts by weight of pigment dispersion. The method also comprises applying a coating of the composition on the substrate. And, the method additionally comprises curing the coating on the substrate to thereby form the photovoltaic backsheet.

As will be realized, the invention is capable of other and different embodiments and its several details are capable of modifications in various respects, all without departing from the invention. Accordingly, the drawings and description are to be regarded as illustrative and not restrictive.

BRIEF DESCRIPTION OF THE DRAWINGS

The inventive subject matter disclosed herein may take form in various components and arrangements of components, and in various steps and arrangements of steps. The drawings and examples are only for purposes of illustrating preferred embodiments and are not to be construed as limiting. Further, it is to be appreciated that the drawings may not be to scale.

Figure 1 is a schematic cross sectional view of a preferred embodiment photovoltaic backsheet in accordance with the invention.

Figure 2 is a graph of ultraviolet light transmission over a range of wavelengths for various preferred embodiment coatings demonstrating their relatively low transmission properties.

Figure 3 is a graph of ultraviolet light transmission over a range of wavelengths for an uncoated PET film.

DETAILED DESCRIPTION OF THE EMBODIMENTS

In accordance with one embodiment, a photovoltaic backsheet as essentially described herein is provided. The backsheet generally comprises a substrate and a coating or other layer disposed along a face or region of the substrate. The coating may include one or more fluorinated agents and may optionally be used in conjunction with an adjacent layer or region of ethylene vinyl acetate (EVA) to produce a complete backsheet with a fluorinated coating positioned toward the exterior to protect the product from weathering. As well, the coating may be coated or otherwise applied onto a substrate of hydrolytically stable polyethylene terephthalate (PET) to form a more durable product.

In accordance with another embodiment, a photovoltaic module having a backsheet as essentially described herein is provided. The backsheet may be positioned with the coating directed toward the inside of the module to protect the PET substrate from chemicals within the photovoltaic cell. As well, the coating may be coated or otherwise applied onto a hydrolytically stable PET substrate to form a more durable product. Photovoltaic modules include one or more solar cells. As generally known, such solar cells convert solar energy into direct current electricity via the photovoltaic effect. Photovoltaic modules generally comprise one or more solar cells, various electrical connectors and contacts, an optional encapsulant, and a backsheet as described herein.

In accordance with still another embodiment, a method is provided for making a photovoltaic module and/or backsheet as essentially described herein.

For clarity and simplicity, the present specification shall refer to structural and/or functional elements, relevant standards and/or protocols, and other components that are commonly known in the art without further detailed explanation as to their configuration or operation except to the extent they have been modified or altered in accordance with and/or to accommodate the preferred embodiment(s) presented herein.

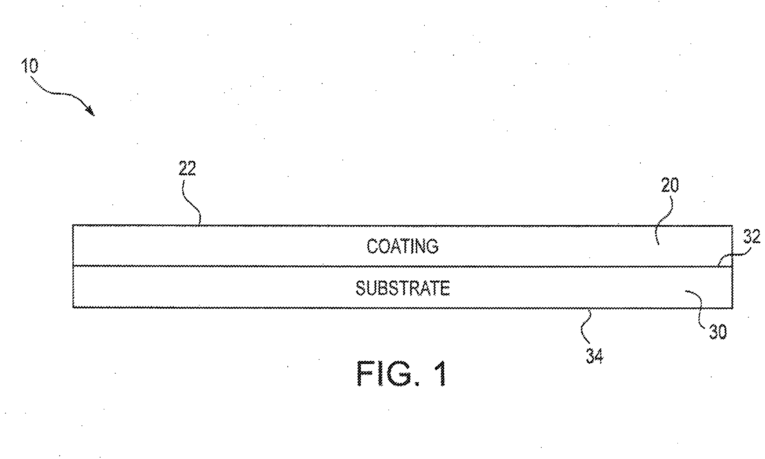

With reference now to FIGURE 1, there is illustrated an exemplary photovoltaic backsheet in accordance with one embodiment of the present inventive subject matter. The backsheet includes a substrate and a coating applied to at least one major surface of the substrate. The backsheet 10 comprises a substrate 30 defining oppositely directed first and second surfaces 32 and 34, respectively. The backsheet 10 also comprises at least one coating layer(s) 20 disposed on the substrate 30. In the configuration depicted in Figure 1, the coating 20 is disposed upon the first surface 32 of the substrate 30 and the coating 20 defines an otherwise exposed face 22.

Substrates

In practice, the substrate is preferably a polymer film. Suitable polymer films include, for example and without limitation, polyester films or more specifically polyethylene terephthalate (PET) film; polyethylene napthalate and a coextrudate of polyethylene terephthalate/polyethylene napthalate. It is also contemplated that the substrate may include other polymers such as polyethylene-based resins, polypropylene-based resins, cyclic polyolefin-based resins, polystyrene-based resins, acrylonitrile-styrene copolymers (AS resins), acrylonitrile-butadiene-styrene copolymers (ABS resins), polyvinyl chloride-based resins, fluorine-based resins, poly(meth)acrylic resins, polycarbonate-based resins, polyamide-based resins, polyimide-based resins, polyamideimide-based resins, polyaryl phthalate-based resins, silicone-based resins, polysulfone-based resins, polyphenylenesulfide-based resins, polyethersulfone-based resins, polyurethane-based resins, acetal-based resins, cellulose-based resins, and the like. Fillers may also be included in the substrate film, where their presence may improve the physical properties of the substrate, for example, higher modulus and tensile strength. They may also improve adhesion of the coating to the substrate film. In one embodiment, the film has a thickness from about 1 mil to about 10 mils. In yet another embodiment, the film has a thickness from about 2 mils to about 7 mils. In still a further embodiment, the film has a thickness of about 5 mils.

Coatings

Various coatings can be applied to the substrate. Generally, the coatings comprise at least one fluorinated agent such as a fluoropolymer and/or a fluorinated vinyl ether. Various preferred coating compositions are set forth below in Tables 1 and 2.

Table 1 set forth below lists various proportions of components in a preferred embodiment coating composition.

Table 1 - Preferred Coating Compositions

| Preferred Amounts (g) | Most Preferred Amounts (g) | Component |
|---|---|---|
| 20 - 40 | 30 | Acrylic |
| 50 - 120 | 70 | Polyvinylidene fluoride |
| 1 - 20 | 7 | Crosslinker |
| 50 - 120 | 78 | Titanium dioxide pigment |
| 20 - 40 | 30 | Cyclohexanone solvent |
| 20 - 70 | 30 | Acetate ester solvent |
| 30 - 50 | 40 | Butyrolactone solvent |
| 0.1 - 1 | 0.29 | Solsperse dispersant |
| 0.1 - 2 | 0.92 | PTSA catalyst |
| 0.1 - 4 | 2.15 | UV absorber |
| 0.1 - 2 | 1 | Antioxidant |

In one embodiment and generally summarized in Table 1, the coating is a composition comprising polyvinylidene fluoride (PVDF) and at least one acrylic polymer in combination with other additives and/or adjuncts, e.g., such a crosslinker, white pigment dispersion, catalyst, UV (ultraviolet) absorber, solvents, etc.

A wide range of polyvinylidene fluoride resins can be used. Preferred polyvinylidene resins include but are not limited to copolymers of vinylidene fluoride and hexafluoropropylene. Corresponding homopolymers of polyvinylidene fluoride can also be used. An example of a preferred commercially available polyvinylidene resin is Kynar Flex 2821 available from Arkema Inc. of North America. Examples of preferred commercially available copolymer polyvinylidene fluoride resins include those available from Arkema Inc. of Philadelphia, PA. Examples of preferred commercially available homopolymer polyvinylidene fluoride resins include those available from Arkema. All of these can be used separately or in combination.

A wide range of acrylic polymers and/or resins can be used. Preferably, the acrylic polymer is formed from methyl methacrylate, n-butyl methacrylate, hydroxyethyl methacrylate and methacrylic acid. An example of a preferred material for use as the acrylic component is Elvacite 4402 from Lucite International.

The preferred embodiment coating compositions summarized in Table 1 utilize the acrylic component, i.e. one or more acrylic polymers and/or resins, and the polyvinylidene fluoride component in various weight proportions relative to one another. Preferably the acrylic component is used in a proportion of from about 20 to about 40 parts by weight relative to a weight proportion of from about 50 to about 120 parts by weight of the polyvinylidene fluoride component. Most preferably, the acrylic component is used in a weight proportion of about 30 parts by weight relative to about 70 parts by weight of the polyvinylidene fluoride component. For certain applications in which performance of the coating is particularly important with regard to resistance to cold cracking, and it is desired that the coating exhibit excellent contrast ratio, and whiteness, the weight percent of the acrylic polymer(s) ranges from about 20% to about 40%, and most preferably about 20%. This weight percent of acrylic polymer(s) is based upon the total weight of the acrylic polymer (s) and the polyvinylidene fluoride in the composition.

The preferred embodiment compositions preferably also include one or more crosslinkers. Preferably the crosslinker is a melamine crosslinker such as Cymel 303 available from Cytec Industries of New Jersey. Preferably, the crosslinker is used in a proportion of from about 1 to about 20 parts by weight relative to a weight proportion of from about 70 to about 160 parts by weight of the total weight of the acrylic component and the polyvinylidene fluoride. Most preferably, the crosslinker is used in a weight proportion of about 7 parts by weight relative to about 100 parts by weight of the total amount of acrylic components and polyvinylidene fluoride. For applications in which resistance to cold cracking and appearance, i.e. good contrast ratio and whiteness, are important, the weight percent of crosslinker is from about 7% to about 10%. These percentages are the weight amount of crosslinker used based upon the total weight of the polyvinylidene fluoride and acrylic polymer(s).

The preferred embodiment compositions may also comprise one or more pigments. Pigments and their use are described in greater detail herein as the pigments are preferably used in both preferred embodiment compositions referenced in Tables 1 and 2.

The coating may also comprise one or more solvents, dispersants, catalysts, and stabilizers, antioxidants processing aids, and/or thermal stabilizers. Non-limiting examples of suitable solvents include acetate ester solvent, butyrolactone solvent, cyclohexanone and combinations thereof. A wide array of dispersants can be used. Examples of a preferred polymeric dispersant that is commercially available include Solsperse 17000 and Solsperse 32000 from Lubrizol. Similarly, various catalysts can be included in the coating compositions. A preferred catalyst is p-toluenesulfonic acid (PTSA). This catalyst is commercially available from numerous sources such as from Cytec Industries under the designation Cycat 4040. Various light stabilizers can also be included in the coating composition. A preferred light stabilizer is a UV absorber such as Tinuvin 928 available from Ciba Specialty Chemicals. Tinuvin 928 is 2-(2H-Benzotriazole-2-yl)-6-(1-methyl-1-phenylethyl)-4-(1,1,3,3-tetramethylbutyl)phenol. The coating compositions can also include one or more antioxidants such as those commercially available from Ciba Specialty Chemicals under the designation Irganox, and specifically Irganox 1076, 1010, 245. In addition, antioxidants from Cytec can be used such as Cyanox 1790. In addition, various processing aids and thermal stabilizers can be included in the coating compositions. Examples of these include Irgatos 126 and Irganoz B225, both commercially available from Ciba Specialty Chemicals.

In another alternate embodiment, the coating comprises a fluorinated vinyl ether with an isocyanate crosslinker in combination with other additives and/or adjuncts.

Table 2 set forth below lists various proportions of components in a preferred embodiment coating composition.

Table 2 - Preferred Coating Compositions

| Preferred Amounts (g) | Most Preferred Amounts (g) | Component |
|---|---|---|
| 80 - 120 | 100 | Fluorinated vinyl ether |
| 5-35 | 9-28 | Isocyanate crosslinker |
| 0.5 - 1 | 0.72 | UV absorber |
| 1-10 | 5 | Solvent |
| 0.05 - 1 | 0.1 - 0.6 | Catalyst |
| 0.05 - 1 | 0.1 - 0.5 | Flow aid |
| 50 - 150 | 80 - 130 | Titanium dioxide dispersion |

In the preferred embodiment compositions of Table 2, a wide range of fluorinated components such as fluorinated vinyl ethers can be used. The fluorinated vinyl ether resin is preferably a fluoroethylene-alkyl vinyl ether and is available commercially from Asahi Glass under the designations LF200, LF600X, LF910LM. Another useful fluorinated vinyl ether polymer is a copolymer from Daikin Industries, Ltd., under the designation of GK570.

A wide range of isocyanate crosslinkers can be used. Preferably, the isocyanate crosslinker is an aliphatic polyisocyanate such as available from Bayer under the designations Desmodur N-100 and N-3390.

The preferred embodiment coating compositions summarized in Table 2 utilize the fluorinated vinyl ether component and the isocyanate crosslinker in various weight proportions relative to one another. Preferably, the isocyanate crosslinker is used in a proportion of from about 5 to about 35 parts by weight relative to a weight proportion of from about 80 to about 120 parts by weight of the fluorinated vinyl ether. Most preferably, the isocyanate crosslinker is used in a weight proportion of from about 9 to about 28 parts by weight relative to about 100 parts by weight of the fluorinated vinyl ether component.

The preferred coating composition of Table 2 can also comprise one or more UV absorbers. A preferred UV absorber is the previously noted material commercially available from Ciba Specialty Chemicals under the designation Tinuvin 928. Another material also available from Ciba can be used, Tinuvin 384. Tinuvin 384 is believed to be 95% Benzenepropanoic acid, 3-(2H-benzotriazol-2-yl)-5-(1,1-dimethylethyl)-4-hydroxy-, C7-9-branched and linear alykl esters and 5% 1-methoxy-2-propyl acetate.

The preferred coating composition of Table 2 may also comprise one or more solvents such as 2,4-pentane dione.

The coating composition may also comprise dispersants such as Solsperse 32000 from Lubrizol, catalysts such as dibutyl tin dilaurate, flow aids, and other components.

The preferred embodiment coating compositions set forth in Tables 1 and 2 may include additional components and agents. Furthermore, it will be appreciated that one or more component(s) of the composition summarized in Table 2 can be incorporated in the composition summarized in Table 1; and vice-versa. Moreover, it will also be understood that in no way is the present invention and the various preferred compositions and components therein limited to the particular details and sources noted herein.

Preferably, pigment is included in each of the preferred embodiment coating compositions summarized in Tables 1 and 2. Pigment particles are typically provided in conjunction with a binder. For example, suitably, mica may be used, up to a pigment to binder ratio of 1.1 to 1, to help reduce the moisture vapor transmission rate. Nano particle titanium dioxide ($TiO_2$) may be used, up to a pigment to binder ratio of 1.1 to 1, to block UV light transmission. However, the preferred embodiment compositions can utilize pigment in a wide range of pigment to binder ratios. Typically, the amount of pigment is from about 0.1 to about 1.1, more preferably from about 0.5 to about 0.9, and more preferably from about 0.6 to about 0.7 expressed as a weight ratio of pigment to binder. Nearly any type of pigment and associated binder can be used such that the pigment and binder are compatible and appropriate for the end use application and incorporation in a photovoltaic backsheet.

When using titanium dioxide pigment, it is preferred to provide such in the form of a pigment dispersion. Various solvents or liquid vehicles can be used in conjunction with the titanium dioxide pigment. Preferred examples include but are not limited to propylene glycol monomethyl ether acetate (PMAC), xylene, and combinations thereof. One or more dispersants may also be used such as the previously noted Solsperse 32000 from Lubrizol. An example of a preferred titanium dioxide dispersion is a pigment dispersion comprising about 100 parts by weight of titanium dioxide pigment, about 50 parts by weight of PMAC, about 50 parts by weight xylene, and about 0.3 parts by weight of dispersant. A preferred commercially available titanium dioxide is Ti-Pure R-960 from DuPont.

Suitably, the coating is applied by one or more techniques such as reverse roll, gravure, slot die, meyer rod, spray, etc. After application, the coating is dried and/or cured. This may be achieved for the compositions of Table 1, for example, by allowing the PVDF product to fuse and cure at temperatures from about 280°F (138°C) to about 360°F (182°C) for from about 1 minute to about 5 minutes. The fluorinated vinyl ether may be cured from about 200°F (93°C) up to about 360°F (182°C) for from about 1 minute to about 5 minutes.

In a suitable embodiment, the coating thickness or coating weight is in the range of about 0.1 mil to about 1 mil. In yet another suitable embodiment, the coating thickness or coating weight is in the range of about 0.25 mil to about 0.75 mil. In yet another suitable embodiment, the coating thickness or coating weight is in the range of about 0.25 mil to about 0.5 mil. In still a further suitable embodiment, the coating thickness or coating weight is about 0.25 mil.

The coated film as described herein is particularly well suited to use as a backsheet for a photovoltaic module. Such a module generally includes a semiconductor or other suitable photovoltaic device which may be partially or fully jacketed or otherwise encased in an encapsulant or otherwise sandwiched between or covered by a suitable protective material, e.g., such as ethylene vinyl acetate (EVA). In such instances, the coated film described herein is optionally adhered or otherwise laminated to the back side or other suitable surface of the construction. Optionally, an adhesive is used to bond or join the coated film to the construction, e.g., such as a pressure sensitive adhesive (PSA). It is to be appreciated that the coating provides desirable strength, weather resistance, UV (ultraviolet) resistance and moisture barrier properties to the backsheet to as to protect the photovoltaic module.

TRIALS AND EXAMPLES

FIRST TRIAL

In a first trial, nine coatings were prepared and coated on 5 mil clear PET substrates. The formulations for the example coatings are set forth in the tables that follow.

Of the examples from the first trial, it appears that those examples having a lower acrylic level of 20% performed best overall. This observation is mainly based upon these examples exhibiting the best performance for cold crack, contrast ratio and whiteness.

Of the examples from the first trial, it appears that those examples having a crosslinker level of 7.3 performed best overall. Preferably, this level is taken as the minimum preferred level insomuch as those examples with lower levels did not perform as well. Notably, increasing the level of crosslinker promotes better adhesion.

Of the examples from the first trial, it appears that those examples with a 0.72 pigment to binder ratio performed best overall. Notably, increasing the pigment did not increase the hiding nor the whiteness. The 0.72 level appears to be at the saturation point.

Of the examples from the first trial, it appears that those examples having a coating thickness of 0.75 mils performed best for hiding and whiteness, while those examples having a coating thickness of 0.5 mils performed best for adhesion, and those examples having a coating thickness of 0.25 mils performed best for cold crack.

Also tested was the UV transmission for all nine examples of the first trial. All are less than 0.12% transmission. The UV transmission for an uncoated 5 mil PET was also tested as a control.

As well, color and contrast ratio data was obtained for the examples.

Table 3 - Compositions of Coatings

| Example | Acrylic (wt. % relative to PVDF and Acrylic content) | Crosslinker (wt. % relative to PVDF and Acrylic content) | Pigment/Binder Ratio | Dry Coating Thickness (mil) |
|---|---|---|---|---|
| 1 | 30 | 7.3 | .73 | .75 |
| 2 | 30 | 9.125 | .84 | .5 |
| 3 | 30 | 5.475 | .62 | .25 |
| 4 | 40 | 7.3 | .84 | .25 |
| 5 | 40 | 9.125 | .62 | .75 |
| 6 | 40 | 5.475 | .73 | .5 |
| 7 | 20 | 7.3 | .62 | .5 |
| 8 | 20 | 9.125 | .73 | .25 |
| 9 | 20 | 5.475 | .84 | .75 |

Table 4 - Compositions of Coatings

| Example | Acrylic Resin (g) | PVDF Resin (g) | Melamine Crosslinker (g) | White Pigment Dispersion (g) | Acetate Ester Solvent (g) | Butyrolactone Solvent (g) | Dispersant (g) | PTSA Catalyst (g) | Light Stabilizer (g) | Dry Coating Thickness (mil) |
|---|---|---|---|---|---|---|---|---|---|---|
| 1 | 97.10 | 226.57 | 23.63 | 422.55 | 216.86 | 106.81 | 0.93 | 10.88 | 25.32 | .75 |
| 2 | 84.64 | 197.49 | 25.74 | 431.03 | 189.03 | 93.10 | 0.81 | 10.70 | 24.04 | .5 |
| 3 | 112.05 | 226.57 | 17.72 | 352.77 | 216.86 | 106.81 | 0.93 | 10.31 | 24.89 | .25 |
| 4 | 115.66 | 173.49 | 21.11 | 434.36 | 193.73 | 95.42 | 0.71 | 10.71 | 23.93 | .25 |
| 5 | 142.64 | 213.96 | 32.54 | 402.11 | 238.92 | 117.68 | 0.88 | 11.05 | 27.03 | .75 |
| 6 | 132.66 | 198.98 | 18.16 | 425.58 | 222.20 | 109.44 | 0.82 | 10.89 | 25.19 | .5 |
| 7 | 72.95 | 291.81 | 26.63 | 404.44 | 244.39 | 120.37 | 1.20 | 11.06 | 26.88 | .5 |
| 8 | 63.20 | 252.79 | 28.83 | 419.54 | 211.71 | 104.28 | 1.04 | 10.87 | 25.44 | .25 |
| 9 | 59.24 | 236.98 | 16.22 | 437.42 | 198.47 | 97.75 | 0.97 | 10.72 | 23.81 | .75 |

In the first trial, the coating constituents were obtained from the following sources:

Table 5 - Designations and Sources of Components in Coatings

| Product Designation | Constituent | Source |
|---|---|---|
| Elvacite 4402 | Acrylic resin | Lucite International |
| Kynar Flex 2821 F-LG | PVDF resin | Arkema |
| Cymel 303 | Melamine crosslinker | Cytec |
| N/A | White pigment dispersion | Gibraltar Chemical Works |
| Exxate 700 | Acetate ester solvent | Univar |
| N/A | Butyrolactone solvent | Univar |
| Solsperse 17000 | Dispersant | Lubrizol |
| Cycat 4040 | PTSA Catalyst | Cytec |
| Tinuvin 928 | UV absorber | Ciba Specialty Chemicals |
| 5 mil clear PET | Substrate | SKC |

Cold Crack Rating

The cold crack rating testing was performed on 3 samples of each example. The first sample was tested with no prior exposure, the second sample was tested after being exposed for 1 week to a temperature of 70°C while immersed in water, and the third sample was tested after being exposed for 1 week to a temperature of 105°C. The testing comprised placing the samples in a freezer at -10°C for 16 hours. They were then each taken out and folded back upon themselves at 180 degrees. The samples were then compared to each other and rated on a scale of 1 to 5, with 5 being the best and 1 being the worst. The main factor for cold crack performance appeared to be coating thickness, with the thinner thicknesses being better. The cold crack rating test results are as follows (higher is better):

Table 6 - Results of Cold Crack Testing

| Example | 1st Sample | 2nd Sample | 3rd Sample |
|---|---|---|---|
| 1 | 1 | 3 | 1 |
| 2 | 2 | 5 | 2 |
| 3 | 4 | 5 | 2 |
| 4 | 3 | 6 | 4 |
| 5 | 1 | 4 | 1 |
| 6 | 1 | 2 | 2 |
| 7 | 3 | 4 | 3 |
| 8 | 5 | 5 | 5 |
| 9 | 5 | 1 | 1 |

Contrast Ratio

The contrast ratio was measured by taking color measurements over a black and white background to then determine the amount of hiding each sample provided. The main factor affecting the contrast ratio performance appeared to be the coating thickness. Examples having higher coating thicknesses generally performed relatively better, i.e., having a higher contrast ratio for better hiding. These color measurements were taken using a colorimeter, i.e., Data Color SF600+ (Spherical) 30 mm Aperture.

Lightness-Darkness

The L* value is the measurement of the lightness or darkness of a color, with a higher value being lighter. In CIELAB color space, the coordinate L* represents the lightness of a color, wherein L* = 0 yields black and L* = 100 indicates diffuse white; specular white may be higher. In any event, the lightness of the examples in the first trial were measured using a colorimeter, i.e., Data Color SF600+ (Spherical) 30 mm Aperture, and the main factor affecting performance in this case appears to be the coating thickness, with the examples having a higher coating thickness performing better (i.e., being lighter).

Whiteness Index

Whiteness Index is a measure which correlates the visual ratings of whiteness for certain white and near-white surfaces. Higher values are considered whiter. In any event, the lightness of the examples in the first trial were measured using a colorimeter, i.e., X-Rite 939 (0/45) 4 mm Aperture, and the main factor affecting performance in this case appears to be the coating thickness. The examples having a higher coating thickness performed better, i.e., being whiter. Amount of acrylic was also a factor, with examples having a lower level performing better, i.e., being whiter.

The following table shows the color coordinate values obtained during the measurement of the contrast ratio, lightness and whiteness index. The contrast ratio refers to the opacity of the sample (0 to 100%).

Table 7 - Color Coordinate Values

| Example | DataColor SF600+ (Spherical) 30 mm Aperture | | | | | | X-Rite 939 (0/45) 4 mm Aperture | | | | | |
| | Contrast ratio | L* | a* | b* | C* | h | Whiteness Index | L* | a* | b* | C* | h |
|---|---|---|---|---|---|---|---|---|---|---|---|---|
| 1 | 92.26 | 96.05 | -0.83 | 1.21 | 1.47 | 124.54 | 82.21 | 95.39 | -0.99 | 1.39 | 1.71 | 125.5 |
| 2 | 84.45 | 95.36 | -0.84 | 1.29 | 1.64 | 123.16 | 80.24 | 94.51 | -1.00 | 1.36 | 1.68 | 126.3 |
| 3 | 80.26 | 95.23 | -0.46 | 3.33 | 3.36 | 97.84 | 78.32 | 94.22 | -0.99 | 1.63 | 1.90 | 121.3 |
| 4 | 81.86 | 95.33 | -0.84 | 1.34 | 1.58 | 121.98 | 79.93 | 94.39 | -0.98 | 1.36 | 1.68 | 125.7 |
| 5 | 90.99 | 95.93 | -0.82 | 1.27 | 1.51 | 122.69 | 81.48 | 95.17 | -1.00 | 1.44 | 1.75 | 124.8 |
| 6 | 85.12 | 95.48 | -0.84 | 1.32 | 1.56 | 122.61 | 80.68 | 94.72 | -0.98 | 1.37 | 1.69 | 125.7 |
| 7 | 86.25 | 95.61 | -0.78 | 1.05 | 1.31 | 126.66 | 81.47 | 94.73 | -0.90 | 1.20 | 1.50 | 126.8 |
| 8 | 83.88 | 95.42 | -0.82 | 1.23 | 1.48 | 123.72 | 80.95 | 94.56 | -0.94 | 1.36 | 1.65 | 124.7 |
| 9 | 92.86 | 96.14 | -0.80 | 1.08 | 1.35 | 126.55 | 83.19 | 95.67 | -0.95 | 1.33 | 1.63 | 125.6 |

Adhesion

The adhesion testing was performed on 3 samples of each example. The first sample was tested after being exposed for 1 week to a temperature of 70°C while immersed in water, the second sample was tested after being exposed for 1 week to a temperature of 40°C while immersed in water, and the third sample was tested after being exposed for 1 week to a temperature of 105°C. Each sample was tested by scribing the coated side of the film in a grid pattern with a razor blade. Tape, namely, 3M 898 tape was then applied to the crosshatched area and pulled quickly up. The percentage of material that remained on the sample was determined to be the % adhesion. The adhesion test results, shown as percentage (%) adhesion after testing, are as follows (higher is better):

Table 8 - Results of Adhesion Testing

| Example | 1st Sample | 2nd Sample | 3rd Sample |
|---------|-----------|-----------|-----------|
| 1 | 99 | 100 | 100 |
| 2 | 99 | 100 | 100 |
| 3 | 93 | 100 | 100 |
| 4 | 98.5 | 97 | 100 |
| 5 | 98 | 99 | 99 |
| 6 | 99 | 100 | 100 |
| 7 | 100 | 100 | 100 |
| 8 | 100 | 100 | 100 |
| 9 | 99 | 92 | 100 |

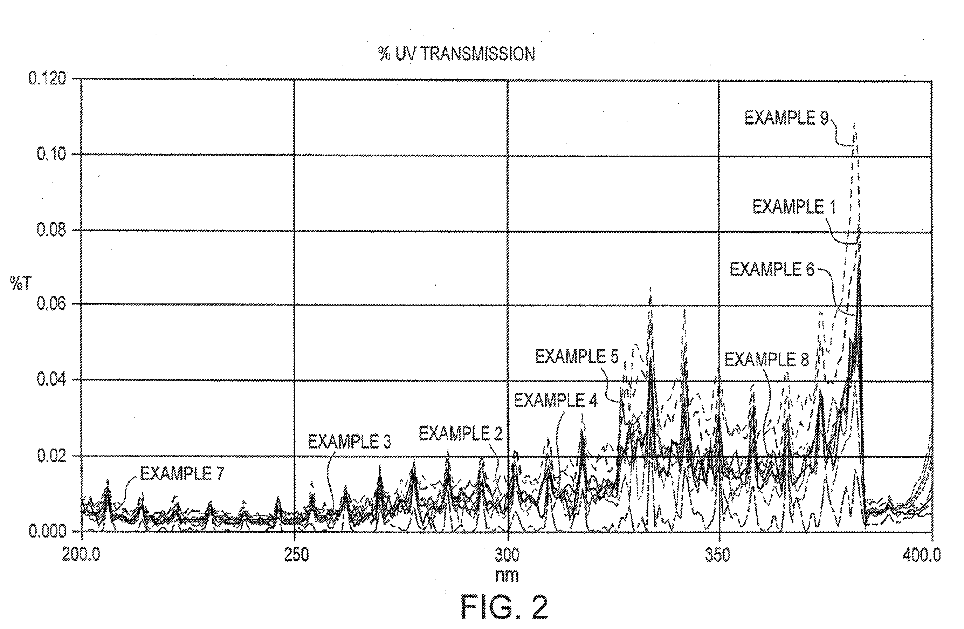

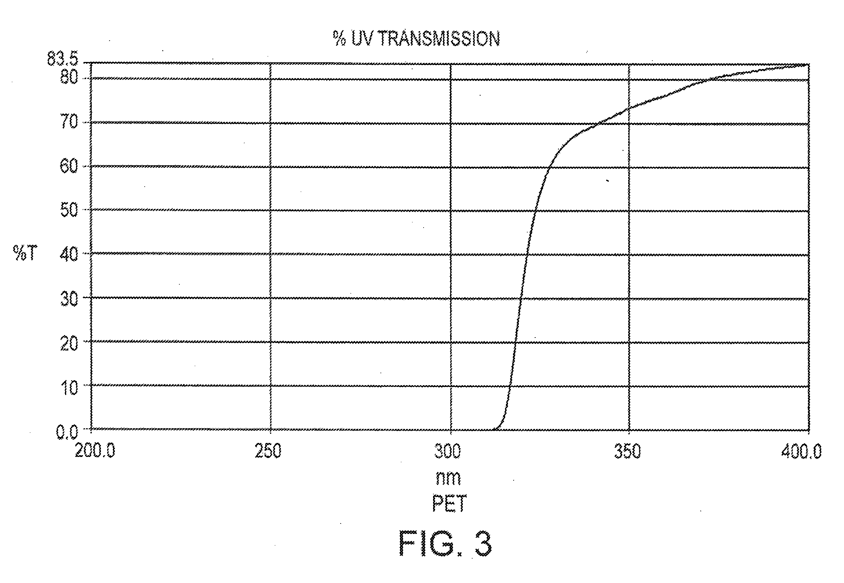

Figures 2 and 3 illustrate the percentage (%) UV light transmission for the examples in the first trial and for an uncoated 5 mil PET film, respectively. As illustrated in Figure 2, all of the coatings in accordance with the preferred compositions set forth in Table 1 exhibited excellent blocking of ultraviolet light. All coatings exhibited a UV light transmission of less than 0.12%.

The nine examples were also tested to determine their moisture vapor transmission rate (MVTR) and oxygen gas transmission rate (OTR). They were characterized by MVTR for moisture vapor transmission rate at 38°C, 100% relative humidity (RH) and OTR for oxygen gas transmission at 38°C, 90% RH. The results are shown below. The MVTR and OTR values show nearly the same results for all nine examples. These values are essentially indistinguishable among the examples using the MVTR and OTR techniques. The values for the MVTR were between 5.2 - 5.9 $g/m^2$ per day. The data are not distinguishable. The values for the OTR were between 25.2 - 27.8 $cc/m^2$ per day. The data are not distinguishable and are only 9.8% relative and just within the precision of the instrument at 10% relative.

MVTR

An approximate 2 inch by 2 inch piece of the example construction was used. The surface area of the example tested was masked to 5.00 $cm^2$. The instrument was operated at 38°C temperature and 100% relative humidity on the test gas side of the coated film. The permeant was water vapor. The flow rate was 100 sccm (standard cubic centimeters per minute) of nitrogen gas. The example underwent a one hour conditioning period. The exam time for each cycle was 60 minutes.

Equilibrium was reached when the transmission rate varied between examinations by less than 1%. The steady-state after introduction of the water vapor into the test-gas side of the diffusion cell took approximately 24 hours. The reported unit of measure was g/($m^2$ per day). The minimum rate achievable was 0.005 g/($m^2$ per day) with a 50.00 $cm^2$ sample size. The bias for this test method was determined at 15% and was derived from comparisons with known-value reference films. The precision was better than 10% relative.

Table 9 - Results of MVTR Testing

| Example | Moisture Vapor Transmission Rate g/(m$^2$ per day) 38°C, 100% RH |
|---------|---------|
| 1 | 5.7 |
| 2 | 5.5 |
| 3 | 5.6 |
| 4 | 5.4 |
| 5 | 5.5 |
| 6 | 5.2 |
| 7 | 5.7 |
| 8 | 5.9 |
| 9 | 5.6 |

OTR

An approximate 2 inch by 2 inch piece of the example construction was used. The surface area of the example tested was masked to 5.00 cm$^2$. The instrument was operated at 38°C. The analysis was conducted at 90% RH. The permeant was oxygen. The flow rate was 20 sccm of oxygen gas. The example underwent a one hour conditioning period. The exam time for each cycle was 60 minutes.

Equilibrium was reached when the transmission rate varied between examinations by less than 1%. The reported unit of measure was cc/(m$^2$ per day). The minimum rate achievable was 0.005 cc/(m$^2$ per day) with a 50.00 cm$^2$ film. The bias for this test method was determined at 15% and was derived from comparisons with a known-value reference film. The precision was better than 10% relative.

Table 10 - Results of OTR Testing

| Example | Oxygen Gas Transmission Rate cc/(m$^2$ per day) 38°C, 90% RH |
|---------|---------|
| 1 | 25.3 |
| 2 | 27.8 |
| 3 | 24.7 |
| 4 | 25.4 |
| 5 | 27.0 |
| 6 | 25.2 |
| 7 | 26.2 |
| 8 | 27.2 |
| 9 | 25.7 |

SECOND TRIAL

In a second trial, eight example coatings were prepared and coated on 5 mil clear PET substrates. Weatherability and chemical resistance testing were conducted on the examples. All eight exhibited 100% adhesion before and after testing. The formulations for the example coatings are set forth in the tables that follow.

As compared to other examples from this trial, examples having 30% acrylic generally fared better, i.e., had lower yellowing and fewer spots, in response to the weatherability testing conducted. However, these examples generally fared worse with respect to the chemical resistance testing conducted. Examples having 7 parts of the crosslinker fared worse with regard to yellowing and spots from the weatherability testing, but fared slightly better in response to the chemical resistance testing. Examples in which the pigment dispersion was used appeared to fare better with regard to both yellowing and number of spots, while those where pigment was merely used appeared to fare better with regard to the chemical resistance testing. Having no PTSA was better for yellowing and spots, but was worse for chemical resistance. Similarly, having no Irganox 1076 was better for yellowing and spots, but was worse for chemical resistance. The Irgafos 126 was not a significant factor for any of the testing conducted. Using the homopolymer PVDF was better for both yellowing and chemical resistance.

In light of the findings from the second trial, a theoretical coating formulation which has the following values, when coated on a 5 mil PET film, appears to be well suited for application as a photovoltaic backsheet: 30 g acrylic, 70 g homopolymer PVDF, 7 g crosslinker, 130 g white pigment (TiO$_2$) dispersion containing 60% pigment to thereby provide 78 g pigment, 30 g cyclohexanone solvent, 30 g acetate ester solvent, 40 g butyrolactone solvent, 0.29 g solsperse dispersant, 0.92 g PTSA catalyst, 2.15 g UV absorber, and 1 g cyanox 1790 antioxidant.

Table 11 - Compositions of Coatings

| Example | Acrylic (wt. % relative to PVDF and Acrylic content) | Melamine Crosslinker (wt. % relative to PVDF and Acrylic content) | White type | PTSA Catalyst (wt. % relative to resin solids) | Antioxidant (wt. % relative to resin solids) | Stabilizer (wt. % relative to resin solids) | PVDF Type |
|---|---|---|---|---|---|---|---|
| 10 | 30 | 7 | TiO$_2$ dispersion | .37 | 0 | 0 | Copolymer |
| 11 | 30 | 7 | TiO$_2$ dispersion | 0 | 1 | 1 | Homopolymer |
| 12 | 30 | 0 | TiO$_2$ pigment | .37 | 0 | 1 | Homopolymer |
| 13 | 30 | 0 | TiO$_2$ pigment | 0 | 1 | 0 | Copolymer |
| 14 | 0 | 7 | TiO$_2$ pigment | .37 | 1 | 0 | Homopolymer |
| 15 | 0 | 7 | TiO$_2$ pigment | 0 | 0 | 1 | Copolymer |
| 16 | 0 | 0 | TiO$_2$ dispersion | .37 | 1 | 1 | Copolymer |
| 17 | 0 | 0 | TiO$_2$ dispersion | 0 | 0 | 0 | Homopolymer |

Table 12A - Compositions of Coatings

| Example | Acrylic (g) | Co-polymer PVDF (g) | Homopolymer PVDF (g) | Melamine Cross-linker (g) | TiO$_2$ dispersion (g) | TiO$_2$ pigment (g) | Acetate Ester Solvent (g) | Butyrolactone Solvent (g) |
|---|---|---|---|---|---|---|---|---|
| 10 | 30 | 70 | | 7 | 130 | | 67 | 33 |
| 11 | 30 | | 70 | 7 | 130 | | 67 | 33 |
| 12 | 30 | | 70 | | | 78 | 67 | 33 |
| 13 | 30 | 70 | | | | 78 | 67 | 33 |
| 14 | 0 | | 100 | 7 | | 78 | 67 | 33 |

**EP 2 695 624 A1**

(continued)

| Example | Acrylic (g) | Co-polymer PVDF (g) | Homopolymer PVDF (g) | Melamine Cross-linker (g) | $TiO_2$ dispersion (g) | $TiO_2$ pigment (g) | Acetate Ester Solvent (g) | Butyrolactone Solvent (g) |
|---|---|---|---|---|---|---|---|---|
| 15 | 0 | 100 | | 7 | | 78 | 67 | 33 |
| 16 | 0 | 100 | | | 130 | | 67 | 33 |
| 17 | 0 | | 100 | | 130 | | 67 | 33 |

Table 12B - Compositions of Coatings (cont.)

| Example | Solsperse 17000 Dispersant (g) | Solsperse 32000 Dispersant (g) | Para Toluenesulfonic Acid (PTSA) Catalyst (g) | UV Absorber (g) | Irganox 1076 Antioxidant (g) | Irgafos 126 Processing Stabilizer (g) |
|---|---|---|---|---|---|---|
| 10 | .29 | 0 | .92 | 2.15 | 0 | 0 |
| 11 | .29 | 0 | 0 | 2.15 | 1 | 1 |
| 12 | .29 | 0 | .92 | 2.15 | 0 | 1 |
| 13 | .29 | 0 | 0 | 2.15 | 1 | 0 |
| 14 | .29 | 2.19 | .92 | 2.15 | 1 | 0 |
| 15 | .29 | 2.19 | 0 | 2.15 | 0 | 1 |
| 16 | .29 | 0 | .92 | 2.15 | 1 | 1 |
| 17 | .29 | 0 | 0 | 2.15 | 0 | 0 |

Table 13 - Designations and Source of Components in Coatings

| Product Designation | Constituent | Source |
|---|---|---|
| Elvacite 4402 | Acrylic resin | Lucite International |
| N/A | Copolymer PVDF resin | Arkema |
| N/A | Homopolymer PVDF resin | Arkema |
| Cymel 303 | Melamine crosslinker | Cytec |
| N/A | White pigment ($TiO_2$) dispersion | Gibraltar Chemical Works |
| Tiona 696 | White pigment ($TiO_2$) | Millennium Chemicals |
| Exxate 700 | Acetate ester solvent | Univar |
| N/A | Butyrolactone solvent | Univar |
| N/A | Cyclohexanone solvent | Univar |
| Solsperse 17000 | Dispersant | Lubrizol |
| Solsperse 32000 | Dispersant | Lubrizol |
| Cycat 4040 | PTSA Catalyst | Cytec |
| Tinuvin 928 | UV absorber | Ciba Specialty Chemicals |
| Irganox 1076 | Antioxidant | Ciba Specialty Chemicals |
| Irgafos 126 | Processing stabilizer | Ciba Specialty Chemicals |
| Irganox 1010 | Antioxidant | Ciba Specialty Chemicals |

**15**

(continued)

| Product Designation | Constituent | Source |
|---|---|---|
| Irganox B225 | Processing and thermal stabilizer | Ciba Specialty Chemicals |
| Irganox 245 | Antioxidant | Ciba Specialty Chemicals |
| Cyanox 1790 | Antioxidant | Cytec |
| 5 mil clear PET | Substrate | SKC |

Weatherability - Yellowing

In one test, the examples were exposed for 2700 hours to a temperature of 85°C while immersed in water. The degree of yellowing in response to the exposure was measured using a colorimeter, where the degree of yellowing was taken as the b* coordinate value in a CIELAB color space. The results are recorded below:

Table 14 - Results of Yellowing Testing

| Example | b* value |
|---|---|
| 10 | 3.01 |
| 11 | 2.11 |
| 13 | 1.45 |
| 14 | 2.44 |
| 15 | 6.56 |
| 16 | 3.61 |
| 17 | 7.49 |
| 18 | 0.01 |

Weatherability - Spotting

In another test, the examples were exposed for 2000 hours to a temperature of 85°C at 85% relative humidity. The number of spots or discolorations exhibited by each in response to the exposure was counted. The results are set forth below:

Table 15 - Results of Spot Testing

| Example | Number of Spots |
|---|---|
| 10 | 5 |
| 11 | 5 |
| 12 | 3 |
| 13 | 3 |
| 14 | 20 |
| 15 | 5 |
| 16 | 9 |
| 17 | 2 |

Additionally, five more examples were prepared per the formulation in the following table and coated on 5 mil PET film. These additional examples (18-22) were as subjected to the same weatherability - spot testing. The results are set forth below:

Table 16 - Results of Spot Testing

| Example | Number of Spots |
|---------|-----------------|
| 18 | 4 |
| 19 | 3 |
| 20 | 7 |
| 21 | 5 |
| 22 | 5 |

Table 17 Composition of Coatings

| Example | Acrylic (g) | Copolymer PVDF (g) | Melamine Crosslinker (g) | TiO$_2$ dispersion (g) | Acetate Ester Solvent (g) | Butyrolactone Solvent (g) | Solsperse 17000 Dispersant (g) | Para Toluenesulfonic Acid (PTSA) Catalyst (g) | UV Absorber (g) | Anti-oxidant |
|---|---|---|---|---|---|---|---|---|---|---|
| 18 | 30 | 70 | 7 | 130 | 67 | 33 | 0.287 | 0.92 | 2.146 | Irganox 1010 Anti-oxidant (1g) |
| 19 | 30 | 70 | 7 | 130 | 67 | 33 | 0.287 | 0.92 | 2.146 | Irganox B225 Processing and thermal stabilizer (1 g) |
| 20 | 30 | 70 | 7 | 130 | 67 | 33 | 0.287 | 0.92 | 2.146 | Irganox 245 Anti-oxidant (1g) |
| 21 | 30 | 70 | 7 | 130 | 67 | 33 | 0.287 | 0.92 | 2.146 | Irgafos 126 Processing Stabilizer (1 g) |
| 22 | 30 | 70 | 7 | 130 | 67 | 33 | 0.287 | 0.92 | 2.146 | Cyanox 1790 Anti-oxidan (1g) |

Chemical Resistance

In yet another test, methyl ethyl ketone (MEK) was applied to a cloth rag. The rag was double rubbed, i.e., once forward and once back, over each example. The number of double rubs until the coating was removed down to the underlying PET film were counted, up to a maximum of 50 double rubs. The results are noted below:

Table 18 - Results of Resistance to MEK

| Example | # of MEK Double Rubs |
|---------|----------------------|
| 10 | 8 |
| 11 | 25 |
| 12 | 50 |
| 13 | 7 |
| 14 | 50 |
| 15 | 25 |
| 16 | 12 |
| 17 | 50 |

THIRD TRIAL

In a third trial, eight example coatings were prepared and coated on 5 mil clear PET substrates. Weatherability testing was conducted on the examples by exposing them for 2000 hours to a temperature of 85°C at 85% relative humidity. All eight exhibited 100% adhesion before and after testing. The formulations for the example coatings are set forth in the tables that follow.

Table 19 - Compositions of Coatings

|  | Example 23 | Example 24 | Example 25 | Example 26 | Example 27 | Example 28 | Example 29 | Example 30 |
|---|---|---|---|---|---|---|---|---|
| Fluorinated vinyl ether (100 g) | LF200 | LF200 | LF600X | LF600X | LF910LM | LF910LM | GK570 | GK570 |
| Isocyanate crosslinker Desmodur N-100 (g) | 11.68471 | 0 | 9.3627 | 0 | 24.71765 | 0 | 13.482 | 0 |
| Isocyanate crosslinker Desmodur N-3390 (g) | 0 | 13.09 | 0 | 10.49 | 0 | 27.69412 | 0 | 15.106 |
| UV absorber Tinuvin 384 (g) | 0.72 | 0.72 | 0.72 | 0.72 | 0.72 | 0.72 | 0.72 | 0.72 |
| UV absorber Tinuvin 928 (g) | 0.72 | 0.72 | 0.72 | 0.72 | 0.72 | 0.72 | 0.72 | 0.72 |
| 2,4-Pentane Dione solvent (g) | 5 | 5 | 5 | 5 | 5 | 5 | 5 | 5 |

(continued)

|  | Example 23 | Example 24 | Example 25 | Example 26 | Example 27 | Example 28 | Example 29 | Example 30 |
|---|---|---|---|---|---|---|---|---|
| 1% T-12 (DiButyl Tin DiLaurate) Catalyst (g) | 0.430108 | 0.215 | 0.3562 | 0.1783 | 0.544306 | 0.272774 | 0.4409 | 0.2208 |
| Flow aid Byk 333 (g) | 0.358424 | 0.15 | 0.2968 | 0.125 | 0.453588 | 0.165 | 0.3674 | 0.15 |
| $TiO_2$ dispersion (g) | 100.3586 | 100.5 | 83.108 | 83.218 | 127.0047 | 127.2946 | 102.88 | 103.03 |

Table 20 - Composition of Titanium Dioxide Dispersion in Coatings

|  | $TiO_2$ dispersion |
|---|---|
| Pigment R960 $TiO_2$ (g) | 600 |
| Propylene Glycol Monomethyl Ether Acetate (PMAC) (g) | 300 |
| Solsperse 32000 (g) | 2 |
| Xylene (g) | 300 |

Table 21 - Designations and Sources of Components in Coatings

| Product Designation | Constituent | Source |
|---|---|---|
| LF200 | Fluorinated vinyl ether resin | Asahi Glass |
| LF600X | Fluorinated vinyl ether resin | Asahi Glass |
| LF910LM | Fluorinated vinyl ether resin | Asahi Glass |
| GK570 | Fluorinated vinyl ether resin | Daikin |
| Desmodur N-100 | Isocyanate crosslinker | Bayer |
| Desmodur N-3390 | Isocyanate crosslinker | Bayer |
| N/A | 2,4-Pentane Dione solvent | N/A |
| Solsperse 32000 | Dispersant | Lubrizol |
| N/A | 1 % T-12 (DiButyl Tin DiLaurate) Catalyst | N/A |
| Tinuvin 384 | UV absorber | Ciba Specialty Chemicals |
| Tinuvin 928 | UV absorber | Ciba Specialty Chemicals |
| Byk 333 | Flow Aid | BYK-Chemi |
| 5 mil clear PET | Substrate | SKC |

After testing, the following observations were made:

Example 23. Noticeable color change. No gloss change. No other detrimental effects.

Example 24. Noticeable color change. No gloss change. Evidence of surface spotting (1 small spot). No other detrimental effects.

Example 25. Noticeable color change. No gloss change. No other detrimental effects.

Example 26. Noticeable color change. No gloss change. No other detrimental effects.

Example 27. Noticeable color change. No gloss change. Evidence of surface spotting (2 small spots). No other detrimental effects.

Example 28. Very noticeable color change. No gloss change. Evidence of surface spotting (1 small spot). No other detrimental effects.

Example 29. Noticeable color change. No gloss change. No other detrimental effects.

Example 30. Very noticeable color change. No gloss change. No other detrimental effects.

In summary, from the third trial, it appears that using Desmodur N-100 gives slightly better results than Desmodur N-3390. Although, Desmodur N-3390 also performed satisfactorily. The LF600X and the GK570 appear to be slightly better for the resin system, although again, they all performed satisfactorily.

In any event, it is to be appreciated the present specification has been set forth with reference to preferred embodiments. Modifications and alterations will occur to others upon reading and understanding the present specification. It is intended that the invention be construed as including all such modifications and alterations insofar as they come within the scope of the appended claims or the equivalents thereof.

Many other benefits will no doubt become apparent from future application and development of this technology.

All patents, published applications, and articles noted herein are hereby incorporated by reference in their entirety.

It will be understood that any one or more feature or component of one embodiment described herein can be combined with one or more other features or components of another embodiment. Thus, the present invention includes any and all combinations of components or features of the embodiments described herein.

## Claims

1. A photovoltaic backsheet comprising a cured coating disposed on a substrate, the coating prior to curing comprising: from about 80 to about 120 parts by weight of at least one fluorinated vinyl ether; from about 5 to about 35 parts by weight of at least one isocyanate crosslinker; and from about 50 to about 150 parts by weight of pigment dispersion.

2. The photovoltaic backsheet of claim 1 wherein the amount of fluorinated vinyl ether is about 100 parts by weight.

3. The photovoltaic backsheet of claims 1-2 wherein the fluorinated vinyl ether is a fluoroethylene-alkyl vinyl ether.

4. The photovoltaic backsheet of claims 1-3 wherein the amount of isocyanate crosslinker is from about 9 to about 28 parts by weight.

5. The photovoltaic backsheet of claims 1-4 wherein the coating prior to curing further comprises from about 0.5 to about 1 part by weight of UV absorber.

6. The photovoltaic backsheet of claim 5 wherein the amount of UV absorber is about 0.72 parts by weight.

7. The photovoltaic backsheet of claims 1-5 wherein the coating prior to curing further comprises from about 1 to about 10 parts solvent.

8. The photovoltaic backsheet of claim 7 wherein the amount of solvent is about 5 parts by weight.

9. The photovoltaic backsheet of claims 7-8 wherein the solvent is 2,4- pentane dione.

10. The photovoltaic backsheet of claims 1-9 wherein the amount of pigment dispersion is from about 80 to about 130 parts by weight.

**11.** The photovoltaic backsheet of claims 1-10 wherein the pigment includes titanium dioxide.

**12.** The photovoltaic backsheet of claims 1-11 wherein the pigment dispersion includes titanium dioxide and a solvent selected from the group consisting of propylene glycol monomethyl ether acetate (PMAC), xylene, and combinations thereof.

**13.** The photovoltaic backsheet of claim 1, wherein the coating thickness is in the range of 0.1 mil to 1.0 mil.

**14.** The photovoltaic backsheet of claim 13, wherein the coating thickness is in the range of 0.25 to 0.5 mil.

**15.** A photovoltaic module comprising: at least one solar cell; and a backsheet disposed on the solar cell, the backsheet comprising the backsheet of any of claims 1-14.

FIG. 1

FIG. 2

FIG. 3

| | Europäisches Patentamt |
| --- | --- |
| | European Patent Office |
| | Office européen des brevets |

**EUROPEAN SEARCH REPORT**

Application Number

EP 13 00 4739

## DOCUMENTS CONSIDERED TO BE RELEVANT

| Category | Citation of document with indication, where appropriate, of relevant passages | Relevant to claim | CLASSIFICATION OF THE APPLICATION (IPC) |
| --- | --- | --- | --- |
| E | WO 2012/021279 A1 (MADICO INC [US]; TEMCHENKO MARINA [US]; AVISON DAVID WILLIAM [US]; MAN) 16 February 2012 (2012-02-16) * abstract; claims 1-11 * ----- | 1-15 | INV. C08L27/16 C09D127/16 C09D133/04 H01L31/05 H02N6/00 H01L31/048 C08F214/26 |
| X,P | WO 2010/073735 A1 (LINTEC CORP [JP]; TAKANASHI YASUNARI [JP]) 1 July 2010 (2010-07-01) * abstract; claims 1-4 * * example 11 * ----- | 1-15 | |
| X,P | WO 2010/126000 A1 (DAIKIN IND LTD [JP]; NAGATO MASARU [JP]; IMOTO KATSUHIKO [JP]; NAKAGAW) 4 November 2010 (2010-11-04) * abstract; claims 1-10 * ----- | 1-15 | ADD. H01L31 C09D127 |
| X | EP 1 938 967 A1 (DAIKIN IND LTD [JP]) 2 July 2008 (2008-07-02) * abstract; claims 1-8 * ----- | 1-15 | |
| X | US 2008/264484 A1 (TEMCHENKO MARINA [US] ET AL) 30 October 2008 (2008-10-30) * abstract; claims 1-32 * ----- | 1-15 | TECHNICAL FIELDS SEARCHED (IPC) C08L C09D H01L H02N C08F |

The present search report has been drawn up for all claims

| Place of search | Date of completion of the search | Examiner |
| --- | --- | --- |
| The Hague | 7 January 2014 | Bergmans, Koen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 00 4739

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2014

| Patent document cited in search report | | Publication date | Patent family member(s) | | Publication date |
|---|---|---|---|---|---|
| WO 2012021279 | A1 | 16-02-2012 | CA | 2806878 A1 | 16-02-2012 |
| | | | CN | 103068895 A | 24-04-2013 |
| | | | US | 2011045193 A1 | 24-02-2011 |
| | | | WO | 2012021279 A1 | 16-02-2012 |
| WO 2010073735 | A1 | 01-07-2010 | CN | 102265408 A | 30-11-2011 |
| | | | EP | 2372782 A1 | 05-10-2011 |
| | | | TW | 201034218 A | 16-09-2010 |
| | | | US | 2011256392 A1 | 20-10-2011 |
| | | | WO | 2010073735 A1 | 01-07-2010 |
| WO 2010126000 | A1 | 04-11-2010 | CN | 102414836 A | 11-04-2012 |
| | | | EP | 2426729 A1 | 07-03-2012 |
| | | | US | 2012048352 A1 | 01-03-2012 |
| | | | WO | 2010126000 A1 | 04-11-2010 |
| EP 1938967 | A1 | 02-07-2008 | CN | 101272903 A | 24-09-2008 |
| | | | EP | 1938967 A1 | 02-07-2008 |
| | | | EP | 2418082 A1 | 15-02-2012 |
| | | | ES | 2432017 T3 | 29-11-2013 |
| | | | JP | 5127123 B2 | 23-01-2013 |
| | | | JP | 2007035694 A | 08-02-2007 |
| | | | WO | 2007010706 A1 | 25-01-2007 |
| US 2008264484 | A1 | 30-10-2008 | AU | 2008349415 A1 | 06-08-2009 |
| | | | CA | 2712498 A1 | 06-08-2009 |
| | | | CN | 101909768 A | 08-12-2010 |
| | | | EP | 2247391 A1 | 10-11-2010 |
| | | | JP | 5280460 B2 | 04-09-2013 |
| | | | JP | 2011511456 A | 07-04-2011 |
| | | | KR | 20100121603 A | 18-11-2010 |
| | | | US | 2008264484 A1 | 30-10-2008 |
| | | | US | 2011108086 A1 | 12-05-2011 |
| | | | WO | 2009097024 A1 | 06-08-2009 |

EPO FORM P0459

For more details about this annex : see Official Journal of the European Patent Office, No. 12/82

**EP 2 695 624 A1**

**REFERENCES CITED IN THE DESCRIPTION**

**Patent documents cited in the description**

- US 61287183 A